# EUROPEAN PATENT APPLICATION

(11) **EP 1 882 920 A1**
(43) Date of publication of application: **30.01.2008**
(21) Application number: 06118107.9
(22) Date of filing: 28.07.2006
(51) Int. Cl.: G01L 1/20, G01L 1/18, H01L 41/22, H01L 21/302

(54) **Method of producing a film-type sensor**

(71) Applicant: IEE INTERNATIONAL ELECTRONICS & ENGINEERING S.A., 6468 Echternach (LU)
(72) Inventor: Maoujoud, Mohammed, 2619, Luxembourg (LU); Schumacher, Alain, 54298, IGEL (DE)
(74) Representative: Beissel, Jean

(57) **Abstract**

In the production of a film-type sensor having a first carrier film, a second carrier film and an electric circuit arranged between the first and second carrier films, at least a part of the electric circuit is formed on the first carrier film, by providing a composite film including the first carrier film and a functional layer applied on the first carrier film and patterning the functional layer of the composite film by mechanical machining so as to achieve the desired electric circuit part on the first carrier film.

## Description

### Technical field

The present invention generally relates to the production of film-type sensors.

### Background Art

Film-type sensors normally comprise a first and a second carrier film sandwiching an electric circuit that is sensitive to the physical quantity to be sensed.

In a pressure or force sensor, the first and second carrier films can e.g. be arranged at a certain distance from each other by means of a spacer. An opening in the spacer delimits an active area of the sensor, in which at least two electrodes are arranged in such a way that, in response to a compressive force acting on the active area of the sensor, the first and second carrier films are pressed together against their resiliency and an electrical contact is established between the at least two electrodes.

Some of these pressure or force sensors are configured as simple on/off switches comprising e.g. a first conductive electrode arranged on the first carrier film and a second conductive electrode arranged on the second carrier film in facing relationship with the first electrode. Alternatively, on/off switches could have both first and second electrodes arranged on the first carrier film and an additional conductive element arranged on the second carrier film, in facing relationship with the first and second electrodes.

Other pressure or force sensors have an electrical resistance that varies gradually with the amount of pressure applied. In a first embodiment of such a pressure sensor, a first electrode is arranged on the first carrier film and a second electrode is arranged on the second carrier film in facing relationship with the first electrode. At least one of the electrodes is covered with a layer of pressure sensitive material, e.g. a piezoresistive material, in such a way that when the first and second carrier films are pressed together in response compressive force, an electrical contact is established between the first and second electrodes via the layer of pressure sensitive material. In an alternative embodiment, the first and second electrodes are arranged in spaced relationship on the first carrier film, while an element of pressure sensitive material is arranged in facing relationship with the first and second electrodes. The element of pressure sensitive material shunts the first and second electrodes when brought into contact with them by compressive force.

Pressure or force sensors are of course not the only sensors that may be of in film-based construction. Other sensors envisaged by the present invention include chemical sensors, optical sensors, capacitive sensors etc.

Production of sensors conventionally comprises at least one printing and/or etching step, during which the electric circuit of the sensor is formed on the first and/or the second carrier film. Printing (e.g. screen-printing, ink-jet printing, flexography, photogravure, etc.) of an electric circuit onto a carrier film requires a suitable choice of ink for a given carrier film material (or vice-versa). Numerous compatibility issues have to be considered in this respect, such as adhesion, resistance of the carrier film material to solvents, availability of inks, etc. In some cases, the inks are cured at temperatures from 135°C to 190°C, which may involve shrinkage of the carrier film and thereby cause distortion of the printed pattern. On the other hand, if an etching process is used that involves and/or gives rise to aggressive chemicals, like plasma etching, oxidation etching, laser etching or electrochemical etching, environmental issues are raised.

### Technical problem

It is an object of the present invention to provide an improved method for producing a film-type sensor. This object is achieved by a method as claimed in claim 1.

### General Description of the Invention

In the production of a film-type sensor that comprises a first carrier film, a second carrier film and an electric circuit arranged between the first and second carrier films, at least a part of the electric circuit is formed on the first carrier film. According to an important aspect of the invention, this includes providing a composite film comprising the first carrier film and a functional layer applied on the first carrier film and patterning the functional layer of the composite film by mechanical machining so as to achieve the desired electric circuit part on the first carrier film. Such a machining process is hereinafter also referred to as "dry-phase patterning". As opposed to etching or printing, this mechanical machining involves no wet chemistry at least at the time of the patterning. With respect to printing, this technique has the advantage that it does not require curing. Composite films suitable for the invention are commercially available and may be of different ductility and hardness and or various compositions. The carrier film is preferably a non-conductive polymer, such as PET, PEN, PI, etc, whereas the functional layer may be or comprise a conductive layer, e.g. a conductive polymer, a conductive ceramic, a metal and/or an alloy. The thickness of the functional layer can lie in a range from about 100 nm to several tens of microns. The carrier film can have a thickness of typically 50 to 500 µm. Examples of such composite films with a conductive layer are a laminate of copper film on PET, aluminium-coated PET and ITO on PET. Those skilled will appreciate that this patterning technique can be used in a reel-to-reel process, is very fast (up to 150 m/minute) and nevertheless achieves high resolution (pixel size of about 50 µm). The functional layer may also be or comprise a pressure-sensitive layer, a piezoresistive layer, a piezoelectric layer, an optically sensitive layer and/or a chemically sensitive layer. For the production of a pressure sensor the following piezoelectric materials are advantageously considered: quartz, AlPO₄, GaPO₄, GaAsO₄, ceramics with a perovskite structure (e.g. BaTlO₃, KnbO₃, LiNbO₃, LiTaO₃, BiFeO₃, etc.) or polyvinylidene fluoride polymer (-CH₂-CF₂-)ₙ.

Forming the part of the electric circuit on the first carrier film may further include applying an additional functional layer, e.g. a pressure sensitive layer, a piezoresistive layer, a piezoelectric layer, an optically sensitive layer, a chemically sensitive layer or the like, on top of the patterned functional layer. Application of the additional functional layer may include any suitable application technique, e.g. screen-printing or ink-jet printing, flexography, photogravure, etc. Those skilled will understand that, even if the method comprises a printing step, the amount of material that has to be printed can be considerably reduced by the above patterning step. The additional functional material may be or comprise an electrically conductive layer and/or a pressure-sensitive layer, a piezoresistive layer, a piezoelectric layer, an optically sensitive layer and/or a chemically sensitive layer.

According to different embodiments of the invention, another part of the electric circuit is formed on the second carrier film. This may be done by any suitable conventional technique, e.g. screen-printing, but preferably, forming the part of the electric circuit on the second carrier film includes providing a second composite film including the second carrier film and a functional layer applied on the second carrier film and patterning the functional layer of the second composite film by mechanical machining, so as to achieve the desired electric circuit part on the second carrier film. The functional layer on the second carrier film may include an electrically conductive layer, a pressure-sensitive layer, a piezoresistive layer, a piezoelectric layer, an optically sensitive layer and/or a chemically sensitive layer.

The method may comprise bonding the first and second carrier films together, e.g. by laminating the first and second carrier films together. Bonding the first and second carrier films together may include providing a spacer between the first and second carrier films. This spacer might for instance comprise a resin or a double-sided adhesive. According to a particular embodiment of the method, providing the spacer between the first and second carrier films includes providing a composite film including the second carrier film and a dielectric layer applied on the second carrier film and patterning the dielectric layer by mechanical machining so as to form the spacer.

### Brief Description of the Drawings

Further details and advantages of the present invention will be apparent from the following detailed description of several not limiting embodiments with reference to the attached drawings, wherein:
Fig. 1 is an illustration of an embodiment of a method of producing a film-type sensor;
Fig. 2 is a cross-sectional view of a shunt-mode pressure sensor;
Fig. 3 is a cross-sectional view of a chemical sensor;
Fig. 4 is a cross-sectional view of a through-mode pressure sensor;
Fig. 5 is a cross-sectional view of a of a through-mode pressure sensor with a semiconducting layer;
Fig. 6 is a cross-sectional view of a pressure sensor with a piezoelectric layer;
Fig. 7 is an illustration of a variant for assembling the pressure sensor of Fig. 6;
Fig. 8 is an illustration of another variant for assembling the pressure sensor of Fig. 6;
Fig. 9 is an illustration of sensor components produced by dry-phase patterning.

### Description of Preferred Embodiments

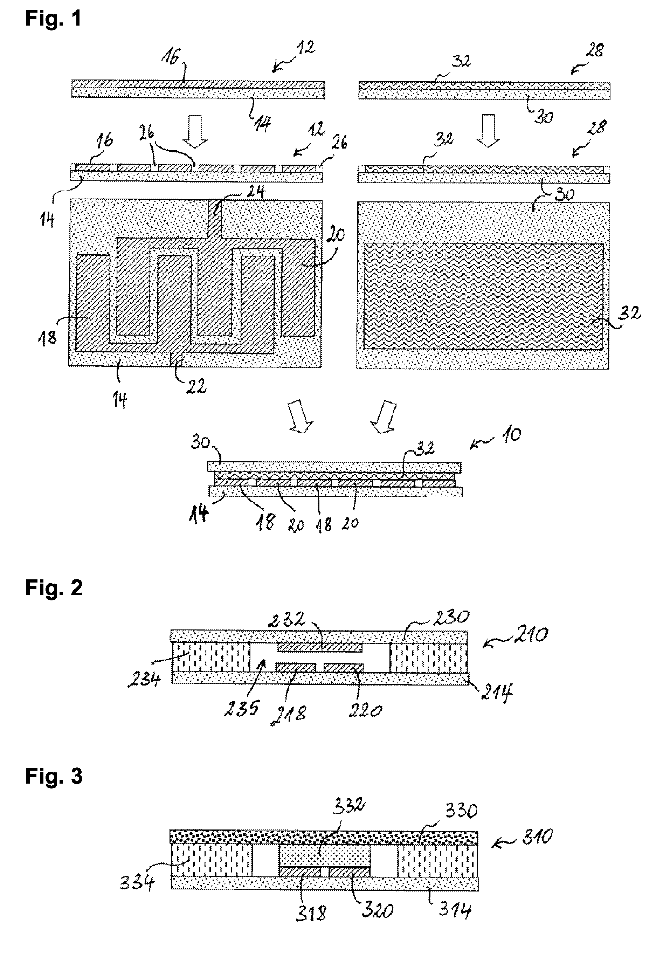

Fig. 1 illustrates steps in production of a film-type sensor 10. The production method includes the provision of a first composite film 12 that comprises a first carrier film 14 and, applied thereon, an electrically conductive layer 16. The first composite film undergoes a drilling-machining process, during which the electrically conductive layer 16 is partially ablated from the composite film 12 in such a way that the remaining portion of the electrically conductive layer 16 forms the desired electric circuit elements on the first carrier film 14. These electric circuit elements are represented, for illustration, as interdigitating electrodes 18, 20 and their leads 22, 24. The result of the drilling-machining process is shown in a cross-sectional view and in a top view. Locations where the electrically conductive layer 16 has been removed are indicated at reference numeral 26. In another branch of the production line, a second composite film 28 is provided, which comprises a second carrier film 30 and, applied thereon, another functional layer 32, e.g. a piezoresistive layer. The second composite film 28 undergoes a drilling-machining process during which parts of the functional layer 32 are removed from the second carrier film 30. The portion of the functional layer 32 that remains on the second carrier film in this case forms a patch.

The patterned composite films 14 are subsequently bonded together in such a way that the interdigitating electrodes 18, 20 and the patch 32 are sandwiched between the carrier films 14, 30. If the functional layer 32 comprises a piezoresistive material, i.e. a material whose resistivity varies as a function of pressure exerted thereon. In this case, the resistance between the electrodes 18, 20 depends on the pressure acting on the sensor 10.

Fig. 2 shows a cross-section of a pressure sensor 210. The pressure sensor 210 comprises a first carrier film 214 on which first and second electrically conductive electrodes 218, 220 have been formed by dry-phase patterning, a second carrier film 230 carrying an electrically conductive patch 232 and a spacer 234 provided with an opening 235. The opening 235 delimits an active area of the pressure sensor 210, in which the first and second electrodes 218, 220 face the patch 232. The spacer 234 normally keeps the first and second carrier films 214, 230 at a distance from one another. When a compressive force acts upon the pressure sensor 210, the first and second carrier films 214, 230 are pressed together in the active area of the pressure sensor 210 and the first and second electrodes 218, 220 thereby get into contact with the patch 232, so that the electrical resistance between the first and second electrodes 218, 220 decreases. Forming the electrically conductive patch 232 on the second carrier film may be achieved by a dry-phase patterning process, by screen-printing, inkjet printing or any other suitable forming technique.

Fig. 3 shows a cross section of a chemical sensor 310 obtained by a method according to the invention. The chemical sensor 310 comprises a first carrier film 314, a second carrier film 330 and an electric circuit arranged between said first and second carrier films. A first part of said electric circuit has been formed on the first carrier film 314 by the already described dry-phase patterning process. In this case the first part of the electrical circuit comprises a first and a second electrode 318, 320 separated from one another. A second part of the electric circuit has been formed on the second carrier film also by dry-phase patterning. The second part in this case is a patch 332 of chemically sensitive material, obtained by removing the chemically sensitive material around the patch 332 during the dry-phase patterning. The first and second carrier films 314, 330 have been bonded together by means of a double-sided adhesive 334. The second carrier film 330 is permeable for the chemical species that can be sensed by the patch 332. When the sensor 310 is exposed to this species, the latter diffuses though the second carrier film 330 and gets into contact with the patch 332. At least one of the electrical properties of the patch changes thereupon so that the presence of the chemical species can be detected.

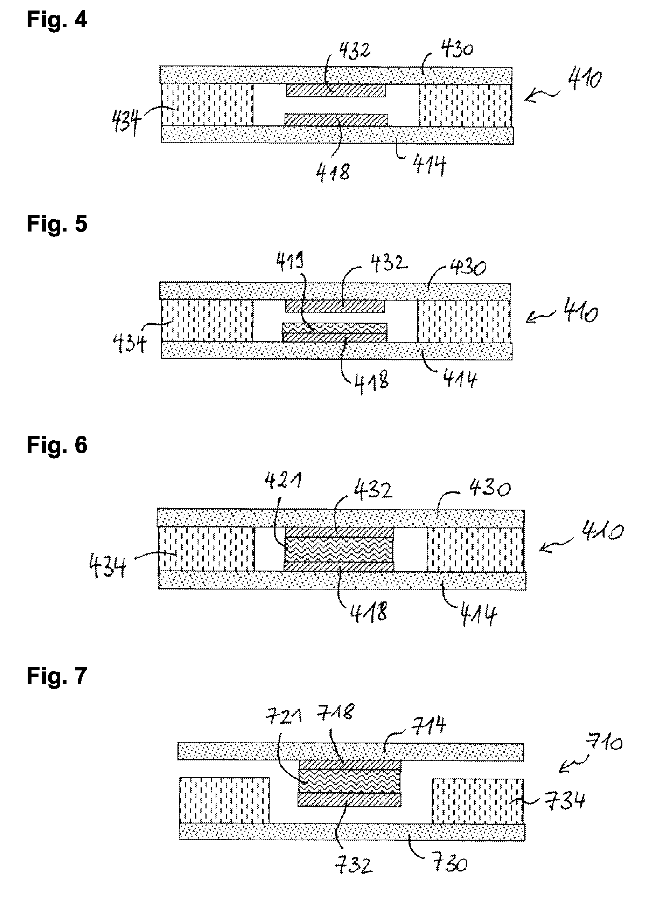

Fig.4 shows a cross-section of a pressure sensor 410. The pressure sensor 410 has been achieved by assembling two dry-phase patterned composite films comprising respectively a carrier film and an electrically conductive layer applied thereon. The first carrier film 414 carries a first electrode 418 obtained from dry-phase patterning of the first composite film, whereas the second carrier film 430 carries a second electrode 432 obtained from dry-phase patterning of the second composite film. Bonding of the first and second carrier films 414, 430 has been achieved by means of double-sided adhesive 434 that plays the role of a spacer in the assembled sensor 410. When a compressive force acts upon the pressure sensor 410, the first and second carrier films 414, 430 are pressed towards one another in an active area, which is defined by an opening in spacer 434. When the compressive force is sufficiently high, the electrodes 418, 432 get into contact and the resistance between them decreases.

Fig. 5 shows a variant of the pressure sensor 410 of Fig. 4. The production of the pressure sensor 410 of Fig. 5 includes an additional step, wherein a pressure-sensitive layer or a conductive layer 419 is applied onto the electrode 418 of the first carrier film 414. The pressure-sensitive or conductive layer provides for a gradual decrease of the electrical resistance between the electrodes 418, 432 when the contact area between the first and second electrodes 418, 432 increases.

Fig. 6 shows yet another variant of the pressure sensor 410 of Fig. 4. In this case, a layer of piezoelectric material 421 has been arranged between the electrodes 418, 432. The voltage between the first and second electrodes 418, 432 thus depends on the pressure applied to the sensor 410.

Fig. 7 illustrates a variant for producing a pressure sensor 710 like the one of Fig. 6. The first electrode 718 has been formed on the first carrier film 714 by dry-phase patterning. Subsequently, the piezoelectric layer 721 and the second electrode 732 have been applied onto the first electrode 718. The spacer 734 between the first and second carrier films 714, 730 has also been formed in a dry-phase patterning process. In more detail, a composite film including the second carrier film 730 and a dielectric layer applied on the second carrier film is provided and the dielectric layer is patterned by mechanical machining, whereby the shape of the spacer 734 is determined.

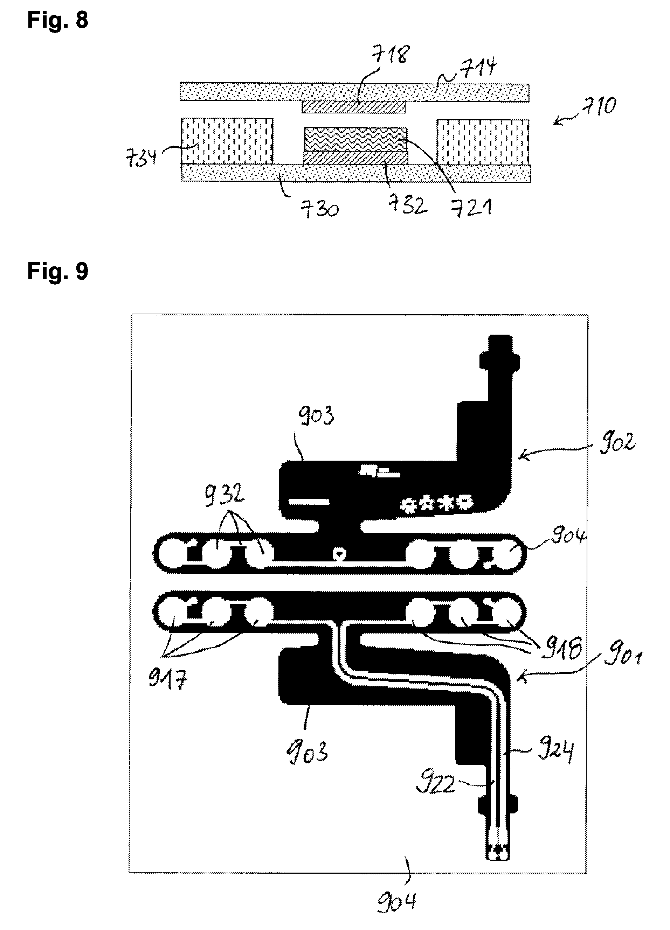

Fig. 8 illustrates another variant for producing a pressure sensor 710 like the one of Fig. 6. In this case, the spacer 734 has also been formed on the second carrier film 730 by dry-phase patterning. After this step the second electrode 732 and the piezoelectric layer 721 have been applied onto the second carrier film 730.

Fig. 9 shows two sensor components 901, 902 obtained by dry-phase patterning of a composite film including a substrate and a conductive layer. The black regions 903 are regions where the conductive layer has been removed; the white regions 904 are the regions where the layer has not been removed. The part of the electric circuit on the first sensor component comprises leads 922, 924 as well as left and right electrodes 917, 918. The part of the circuit on the second sensor component comprises a shunt structure 932. After the patterning step, a spacer with openings at locations corresponding to the left and right electrodes 917, 918 is arranged on the first component and the composite film is folded along the symmetry line between the first and second sensor components 901, 902, in such a way that the sensor components sandwich the spacer. Finally, the sensor is stamped out from the so-formed sandwich structure. When pressure is applied simultaneously on the left and the right sides of the sensor, the left and right electrodes are shunted via the shunt structure. Such sensors may for instance be used for detecting the presence of an occupant on a vehicle seat, e.g. for the seat belt reminder function.

## Claims

1. A method of producing a film-type sensor, said sensor comprising a first carrier film, a second carrier film and an electric circuit arranged between said first and second carrier films, at least a part of said electric circuit being formed on said first carrier film, **characterised in that**
forming the part of the electric circuit on the first carrier film includes
providing a composite film including said first carrier film and a functional layer applied on said first carrier film and
patterning said functional layer of said composite film by mechanical machining.

2. The method according to claim 1, wherein said functional layer comprises an electrically conductive layer.

3. The method according to claim 1, wherein said functional layer comprises a pressure-sensitive layer, a piezoresistive layer, a piezoelectric layer, an optically sensitive layer and/or a chemically sensitive layer.

4. The method according to any one of claims 1 to 3, wherein forming the part of the electric circuit on the first carrier film includes applying an additional functional layer on top of said patterned functional layer.

5. The method according to claim 4, wherein said additional functional layer comprises an electrically conductive layer.

6. The method according to claim 4, wherein said additional functional layer comprises a pressure-sensitive layer, a piezoresistive layer, a piezoelectric layer, an optically sensitive layer and/or a chemically sensitive layer.

7. The method according to any one of claims 1 to 6, wherein a part of said electric circuit is formed on said second carrier film.

8. The method according to claim 7, wherein forming the part of the electric circuit on the second carrier film includes
providing a second composite film including said second carrier film and a functional layer applied on said second carrier film and
patterning the functional layer of said second composite film by mechanical machining.

9. The method according to claim 8, wherein said functional layer applied on the second carrier film comprises an electrically conductive layer.

10. The method according to claim 8, wherein said functional layer applied on the second carrier film comprises a pressure-sensitive layer, a piezoresistive layer, a piezoelectric layer, an optically sensitive layer and/or a chemically sensitive layer.

11. The method according to any one of claims 1 to 10, comprising bonding said first and second carrier films together.

12. The method according to claim 11, wherein bonding said first and second carrier films together includes laminating said first and second carrier films together.

13. The method according to claim 11 or 12, wherein bonding said first and second carrier films together includes providing a spacer between said first and second carrier films.

14. The method according to claim 13, wherein providing a spacer between said first and second carrier films includes
providing a composite film including said second carrier film and a dielectric layer applied on said second carrier film and
patterning said dielectric layer by mechanical machining so as to form said spacer.
